# FASCICULE DE BREVET EUROPEEN

(11) **EP 3 079 178 B1**
(45) Date de publication et mention de la délivrance du brevet: **17.01.2018**
(21) Numéro de dépôt: 16163744.2
(22) Date de dépôt: 04.04.2016
(51) Int. Cl.: H01L 45/00, H01L 27/24

(54) **PROCEDE DE FABRICATION D'UN CIRCUIT INTEGRE COINTEGRANT UN TRANSISTOR FET ET UN POINT MEMOIRE OXRAM**
HERSTELLUNGSVERFAHREN EINES INTEGRIERTEN SCHALTKREISES, IN DEN EIN FET-TRANSISTOR UND EIN OXRAM-SPEICHERPUNKT INTEGRIERT SIND
METHOD FOR MANUFACTURING AN INTEGRATED CIRCUIT CO-INTEGRATING A FET TRANSISTOR AND AN OXRAM MEMORY POINT

(30) Priorité: 09.04.2015 FR 1553070
(43) Date de publication de la demande: 12.10.2016
(73) Titulaire: Commissariat à l'Énergie Atomique et aux Énergies Alternatives, 75015 Paris (FR)
(72) Inventeur: GRENOUILLET, Laurent, 38140 RIVES SUR FURE (FR); MORAND, Yves, 38000 GRENOBLE (FR); VINET, Maud, 44690 LA HAYE FOUASSIERE (FR)
(74) Mandataire: GIE Innovation Competence Group

(56) Documents cités:
- US-A1- 2012 012 944
- BAEK I G ET AL: "Highly scalable non-volatile resistive memory using simple binary oxide driven by asymmetric unipolar voltage pulses", ELECTRON DEVICES MEETING, 2004. IEDM TECHNICAL DIGEST. IEEE INTERNATIO NAL SAN FRANCISCO, CA, USA DEC. 13-15, 2004, PISCATAWAY, NJ, USA,IEEE, 13 décembre 2004 (2004-12-13), pages 587-590, XP010788855, DOI: 10.1109/IEDM.2004.1419228 ISBN: 978-0-7803-8684-6

## Description

L'invention concerne les mémoires OxRAM, et en particulier la cointégration de telles mémoires avec des transistors à effet de champ.

Afin de surmonter les limites en termes de miniaturisation, consommation électrique et complexité de fabrication des technologies mémoires non-volatiles à grille flottante, l'industrie des semi-conducteurs développe différentes technologies alternatives. Parmi les technologies de mémoires non volatiles alternatives en cours de développement, les mémoires de type RRAM présentent un intérêt technique certain. Les mémoires de type RRAM sont basées sur la formation et la rupture réversible d'un filament conducteur : un matériau diélectrique, qui est normalement isolant, peut être forcé à être conducteur à travers un filament ou un chemin de conduction après l'application d'une tension suffisamment élevée. Une fois que le filament est formé, il peut être réinitialisé ou programmé par une tension appliquée de façon appropriée.

Dans le cas particulier des mémoires OxRAM, le filament conducteur est réalisé à partir de lacunes d'oxygène dans un matériau isolant à base d'oxyde métallique. Les mémoires OXRAM bénéficient d'une très bonne stabilité thermique, permettant en théorie de conserver l'information de façon fiable pendant plusieurs années à haute température.

Une cellule de mémoire OxRAM peut être produite à partir d'un point mémoire de base selon trois solutions connues.

Dans une première approche, la plus simple, le point mémoire peut être utilisé comme une cellule de mémoire de base, et utilisé dans une configuration dans laquelle des lignes de bits parallèles sont traversées par des lignes de mots perpendiculaires, avec le matériau de commutation placé entre la ligne de mot et la ligne de bits à chaque point de croisement. Cette configuration est appelée une cellule de point de croisement. Étant donné que cette architecture peut conduire à un grand courant parasite circulant à travers les cellules de mémoire non sélectionnées depuis les cellules voisines, la matrice de points de croisement peut avoir un accès en lecture très lent.

Dans une seconde approche, un élément de sélection peut être ajouté pour éliminer ce courant parasite, mais cet élément de sélection induit une surconsommation électrique.

Dans une troisième approche, un transistor à effet de champ est ajouté, facilitant la sélection d'un point mémoire et optimisant ainsi le temps d'accès, tout en limitant le courant passant dans la cellule, évitant ainsi les surintensités en régime transitoire qui peuvent altérer voire détruire la cellule.

Dans cette troisième approche, la densité d'intégration est cependant fortement altérée, les transistors de sélection occupant une surface non négligeable du substrat du circuit intégré.

Le document 'Higlhy scalable Non-volatible Resistive Memory using Simple Binary Oxide Driven by Asymmetric Unipolar Voltage Pulses' par I.G. Baek et alias, publié par l'IEEE en 2004, décrit un exemple de cointégration de cellules mémoire OxRAM avec des transistors de sélection. En vue d'améliorer la densité d'intégration du circuit intégré, ce document propose d'intégrer les transistors de sélection dans une couche d'avant métallisation ou couche FEOL, et d'intégrer les points mémoire OXRAM dans une couche d'après métallisation ou couche BEOL, à l'aplomb des transistors de sélection.

En pratique, une telle cointégration ne permet pas d'augmenter la densité d'intégration autant que souhaité, tout en impliquant une complexité nettement accrue du procédé de fabrication.

Le document US2012/012944 décrit une structure cointégrant des mémoires RRAM et des transistors. L'isolant de grille des transistors est utilisé pour former des filaments conducteurs des mémoires RRAM.

L'invention vise à résoudre un ou plusieurs de ces inconvénients. L'invention porte ainsi sur un procédé de fabrication d'un circuit intégré incluant au moins un transistor à effet de champ et une cellule mémoire de type OxRam, tel que défini à la revendication 1.

L'invention porte également sur les variantes définies dans les revendications dépendantes. L'homme du métier comprendra que chacune des caractéristiques des revendications dépendantes peut être combinée indépendamment aux caractéristiques de la revendication 1, sans pour autant constituer une généralisation intermédiaire.

L'invention porte aussi sur un circuit intégré, tel que défini dans les revendications annexées.

D'autres caractéristiques et avantages de l'invention ressortiront clairement de la description qui en est faite ci-après, à titre indicatif et nullement limitatif, en référence aux dessins annexés, dans lesquels :
- les figures 1 à 24 sont des vues en coupe transversale durant différentes étapes d'un premier mode de réalisation d'un procédé de fabrication d'un circuit intégré selon l'invention ;
- la figure 25 est une vue en coupe transversale d'une variante de circuit intégré selon l'invention ;
- la figure 26 illustre une vue en coupe schématique de différents matériaux successifs mis en oeuvre dans une cellule OxRAM selon l'invention ;
- les figures 27 à 48 sont des vues en coupe transversale durant différentes étapes d'un deuxième mode de réalisation d'un procédé de fabrication d'un circuit intégré selon l'invention ;
- les figures 49 et 50 illustrent schématiquement des vues de dessus de différentes configurations de circuit intégré selon l'invention ;
- la figure 51 illustre schématiquement une vue en coupe d'une variante de circuit intégré selon l'invention ;
- les figures 52 à 54 illustrent schématiquement des vues de dessus d'autres configurations de circuit intégré selon l'invention.

L'invention propose de cointégrer des cellules mémoire OxRAM et leurs transistors de sélection dans une même couche d'avant métallisation, à partir de mêmes matériaux, formés durant des étapes de dépôt communes.

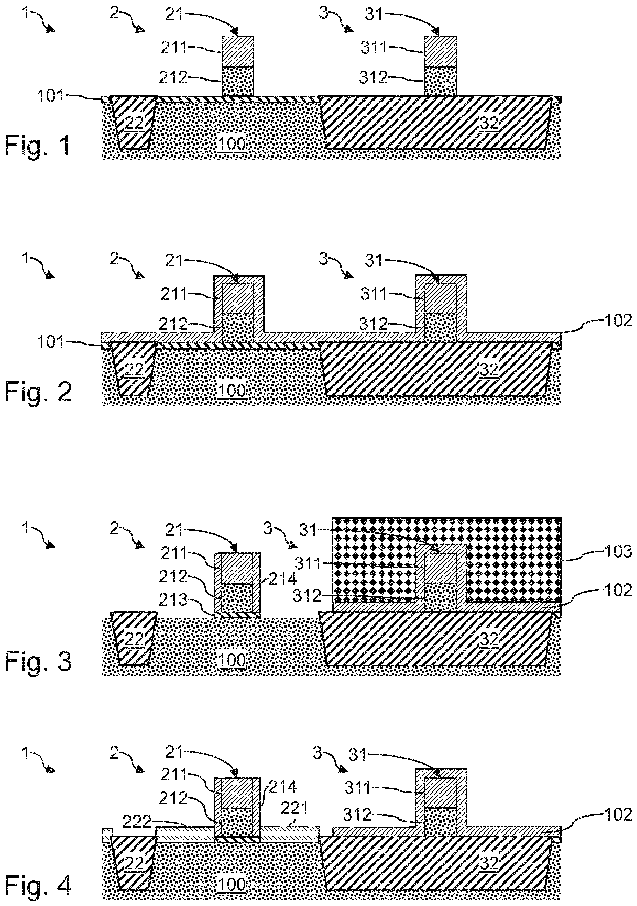

La figure 1 est une vue en coupe transversale d'un circuit intégré 1 au début d'un procédé de fabrication selon un premier mode de réalisation de l'invention. Au début de ce procédé de fabrication, on fournit un substrat semi-conducteur 100, typiquement un substrat semi-conducteur en silicium à dopage résiduel de type P. Dans l'exemple illustré, le substrat 100 est de type massif (bulk en langue anglaise).

Des tranchées d'isolation 22 et 32 sont formées dans le substrat 100. Les tranchées d'isolation 22 et 32 peuvent présenter une profondeur connue en soi. Les tranchées d'isolation 22 et 32 peuvent être réalisées de façon connue en soi en un matériau tel que de l'oxyde de silicium. Le substrat semi-conducteur 100 est recouvert d'une couche d'arrêt de gravure 101. La couche d'arrêt de gravure 101 est ici formée dans un matériau isolant électrique. La couche d'arrêt de gravure 101 est par exemple réalisée dans le même matériau que les tranchées d'isolation 22 et 32, par exemple en oxyde de silicium. La couche d'arrêt de gravure 101 présente par exemple une épaisseur comprise entre 2 et 6 nm.

Une grille factice 21 (dummy gate en langue anglaise) d'un transistor 2 est disposée sur la couche d'arrêt 101, entre les tranchées d'isolation 22 et 32. La grille factice 21 peut avantageusement présenter une épaisseur comprise entre 50 et 150 nm, et de préférence de l'ordre de 100 nm. La grille factice 21 comprend ici un élément semi-conducteur 212 formé sur la couche d'arrêt 101. L'élément semi-conducteur 212 peut être formé en Silicium. L'élément semi-conducteur 212 peut être formé dans le même matériau que le substrat 100 ou un même matériau avec une structure cristallographique différente. L'élément semi-conducteur 212 peut également être formé en polysilicium. L'élément semi-conducteur 212 est par exemple réalisé avec une épaisseur comprise entre 30 et 90 nm, et avantageusement de 70 nm. La grille factice 21 comprend ici un élément isolant 211, formé sur l'élément semi-conducteur 212. L'élément isolant 211 est typiquement réalisé en un matériau de masquage, par exemple du nitrure de silicium. L'élément isolant 211 est par exemple réalisé avec une épaisseur comprise entre 20 et 60 nm, et avantageusement de 30 nm.

Une grille factice 31 d'un point mémoire 3 est ici avantageusement disposée sur la tranchée d'isolation 32. La grille factice 31 comprend ici un élément semi-conducteur 312 formé sur la tranchée d'isolation 32. L'élément semi-conducteur 312 est par exemple formé dans le même matériau que l'élément semi-conducteur 212 et peut présenter la même épaisseur que l'élément semi-conducteur 212. La grille factice 31 comprend ici un élément isolant 311, formé sur l'élément semi-conducteur 312. L'élément isolant 311 est typiquement réalisé dans le même matériau que l'élément isolant 211 et peut présenter la même épaisseur que l'élément isolant 211.

L'utilisation de grilles factices est utilisée dans des procédé dits grille en dernier (gate last en langue anglaise). Les grilles factices 21 et 31 peuvent avoir une géométrie définie de façon connue en soi par des étapes préalables de photolithographie et de gravure sélective. La couche d'arrêt 101 et les tranchées d'isolation 22 et 32 permettent par exemple de réaliser des gravures délimitant les grilles factices 21 et 31, sans graver dans le substrat semi-conducteur 100. Les épaisseurs d'isolant 211 et 311 peuvent par exemple être déposées au préalable par un dépôt de type PECVD (dépôt chimique en phase vapeur assisté par plasma).

Au stade illustré à la figure 2, une couche 102 de matériau isolant est déposée de façon à former des espaceurs de part et d'autre des grilles factices 21 et 31. La couche 102 est par exemple déposée pleine plaque, par exemple par un procédé ALD (dépôt par couche atomique). La couche 102 peut être réalisée en un matériau tel que le nitrure de silicium, ou en des matériaux de type lowK tels que le SiCBN ou le SiOCN. L'épaisseur des espaceurs formés de part et d'autre des grilles factices 21 et 31 est par exemple comprise entre 4 et 8 nm, typiquement 6 nm.

Au stade illustré à la figure 3, un masquage 103 a été défini pour recouvrir la grille factice 31 et une partie de la couche 102 de part et d'autre de la grille factice 31. Le masquage 103 a été retiré par photolithographie entre les tranchées d'isolation 22 et 32, et a été notamment retiré de la grille factice 21. Le masquage 103 n'a ainsi été conservé que sur les zones de points mémoire 3. Par gravure, on a retiré la couche 102 de part et d'autre de la grille factice 21, avantageusement par une gravure anisotrope permettant ainsi de réaliser des espaceurs. Par gravure, on a également retiré la couche d'arrêt 101 de part et d'autre de la grille factice 21, par exemple par attaque d'oxyde. Le semi-conducteur du substrat 100 est ainsi découvert de part et d'autre de la grille factice 21. À l'issue de ces gravures, une partie 213 de la couche d'arrêt est conservée sous l'élément 212 et des espaceurs 214 sont conservés de part et d'autre des éléments 211 et 212 de la grille factice 21.

Au stade illustré à la figure 4, le masquage 103 est retiré de façon connue en soi, de façon à découvrir la couche 102 restant dans la zone du point mémoire 3. Des éléments semi-conducteurs 222 et 221 sont avantageusement formés de part et d'autre de la grille factice 21, sur le semi-conducteur du substrat 100, entre les tranchées d'isolation 22 et 32. Les éléments semi-conducteurs 222 et 221 sont typiquement formés sur une épaisseur avantageusement comprise entre 10 nm et 30nm. Les éléments semi-conducteurs 222 et 221 sont typiquement formés par épitaxie sur le semi-conducteur du substrat 100. Les éléments 222 et 221 sont typiquement obtenus par une croissance par épitaxie sélective de silicium sur du silicium cristallin du substrat 100. Ils peuvent également être obtenus par croissance sélective de SiGe. Les éléments 221 et 222 peuvent faire l'objet d'un dopage par une étape ultérieure d'implantation, non détaillée ici, ou bien par un dopage in-situ lors de l'étape d'épitaxie. Préalablement à l'étape d'épitaxie, un renfoncement (recess en langue anglaise) est avantageusement ménagé dans le matériau du substrat 100, par exemple pour mettre le canal sous contrainte d'un substrat massif 100.

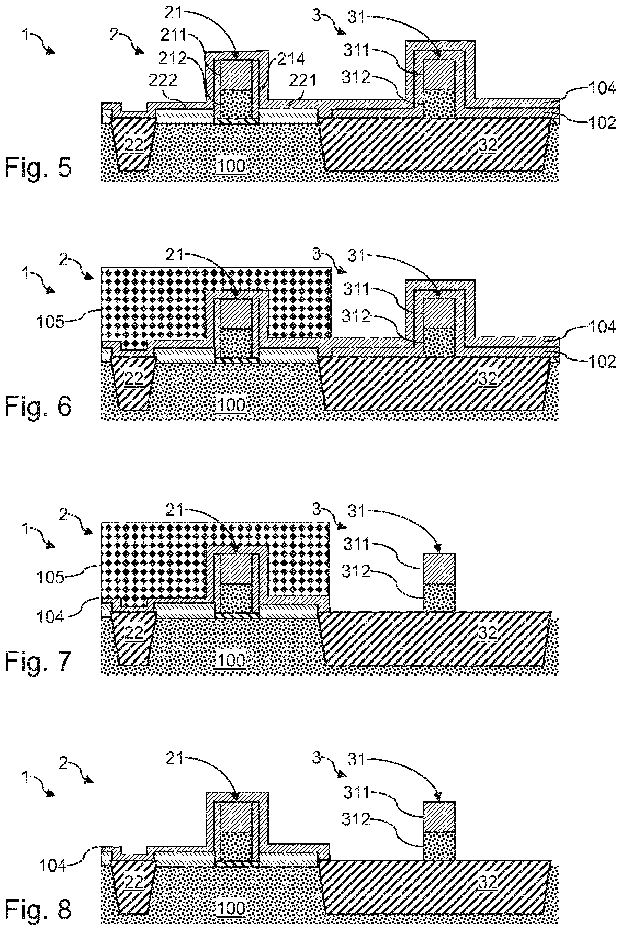

Au stade illustré à la figure 5, une couche d'arrêt 104 a été déposée pour recouvrir la zone du transistor 2. La couche d'arrêt 104 recouvre notamment la zone entre les tranchées d'isolation 22 et 32 et la grille factice 21. La couche d'arrêt 104 est par exemple formée par un dépôt pleine plaque d'un isolant de façon à recouvrir la grille factice 31. La couche d'arrêt 104 est par exemple formée par un dépôt de nitrure (par exemple de type CESL pour Contact Etch Stop Layer en langue anglaise). La couche d'arrêt 104 est par exemple déposée sur une épaisseur d'environ 6 nm.

Au stade illustré à la figure 6, un masquage 105 a été défini pour recouvrir la grille factice 21 et la couche 104 entre les tranchées d'isolation 22 et 32. Le masquage 105 a été obtenu par photolithographie pour découvrir les zones des points mémoire 3. Le masquage 105 n'a ainsi été conservé que sur les zones de transistor 2.

Au stade illustré à la figure 7, on a retiré les couches 102 et 104 de part et d'autre de la grille factice 31 par gravure, par exemple par une gravure isotrope. La tranchée d'isolation 32 est ainsi découverte de part et d'autre de la grille factice 31. Les espaceurs sont retirés de part et d'autre de la grille factice 31, simultanément lors de l'utilisation d'une gravure isotrope.

Au stade illustré à la figure 8, le masquage 105 est retiré de façon connue en soi, de façon à découvrir la couche d'arrêt 104 restant dans la zone du transistor 2.

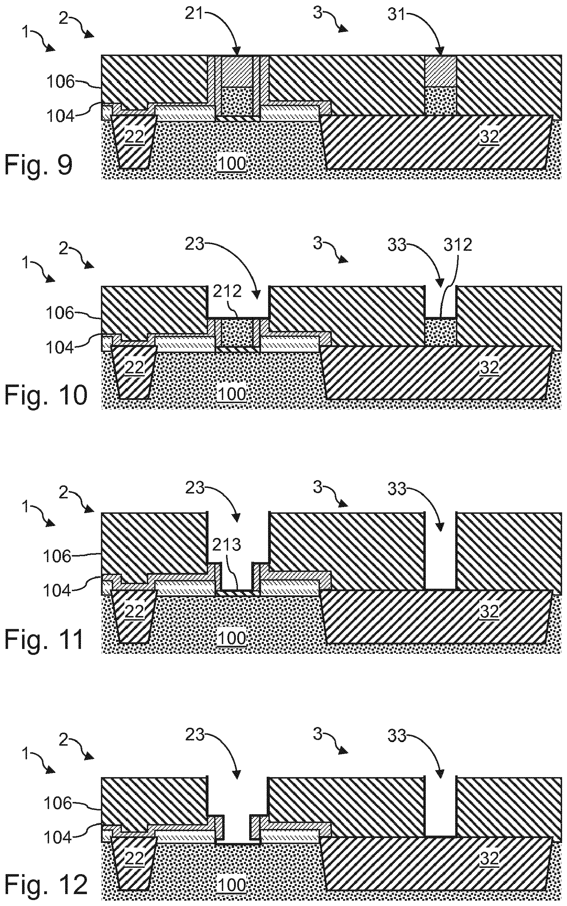

Au stade illustré à la figure 9, on a réalisé une encapsulation du circuit intégré 1 dans une couche d'isolant 106. L'encapsulation est typiquement réalisée pleine plaque au moyen d'un oxyde de silicium. Un polissage mécano chimique a ici ensuite été réalisé et a été interrompu après avoir atteint les éléments 211 et 311. Ces éléments 211 et 311 jouent le rôle de couche d'arrêt pour le polissage mécano chimique.

Au stade illustré à la figure 10, on a procédé au retrait des éléments 211 et 311 jusqu'à atteindre respectivement les éléments semi-conducteurs 212 et 312. Des gorges 23 et 33 sont ainsi formées dans la couche d'isolant 106. Le retrait du nitrure de silicium jusqu'à atteindre les éléments 212 et 312 est par exemple réalisé par gravure chimique humide avec du H₃PO₄ à chaud (par exemple entre 150 et 160°C). Une telle gravure est particulièrement sélective par rapport au Silicium des éléments 212 et 312 et à l'oxyde de Silicium de la couche 106 par exemple.

Au stade illustré à la figure 11, on a procédé au retrait des éléments 212 et 312. Les gorges 23 et 33 atteignent alors respectivement la partie de couche d'arrêt 213 et la tranchée d'isolation profonde 32. Le retrait des éléments 212 et 312 peut par exemple être réalisé par une gravure chimique avec du TMAH (Tetramethylammonium hydroxide) ou du NH₄OH.

Au stade illustré à la figure 12, on a procédé au retrait de la partie de couche d'arrêt 213. La gorge 23 atteint alors le substrat 100. Ce retrait est par exemple effectué par une gravure chimique à l'acide fluorhydrique. Une telle gravure chimique permet en outre de préparer la surface du substrat 100 pour une étape de dépôt ultérieure. Une partie superficielle de la tranchée d'isolation profonde 32 est également gravée.

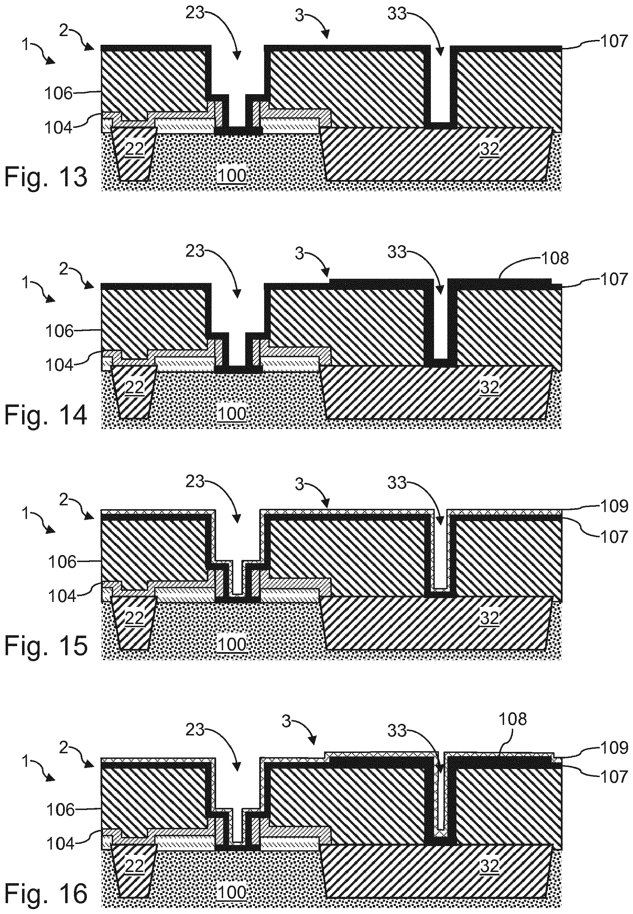

Au stade illustré à la figure 13, on a procédé à la formation d'une couche d'isolant 107 recouvrant la zone du transistor 2 et la zone du point mémoire 3. La couche d'isolant 107 recouvre ici la face supérieure de la couche 106, les flancs des gorges 23 et 33, et respectivement le substrat 100 et la tranchée d'isolation 32 au fond des gorges 23 et 33. Les gorges 23 et 33 ne sont pas intégralement remplies par la couche d'isolant 107. La couche d'isolant 107 est ici formée par un dépôt pleine plaque. La couche d'isolant 107 peut par exemple être déposée par un procédé de type ALD, ce qui permet d'obtenir une épaisseur homogène sur les faces verticales et les faces horizontales.

Le matériau choisi pour la couche d'isolant 107 est un matériau compatible à la fois pour former un isolant de grille pour le transistor 2 et pour former l'isolant du filament conducteur du point mémoire 3. Le matériau de la couche d'isolant 107 peut par exemple être de type Hk ou High-K (un matériau High-K désigne usuellement un matériau dont la constante diélectrique relative est au moins égale à 6). Le matériau de la couche d'isolant 107 peut par exemple être du HfO₂, matériau courant pour réaliser un isolant de grille. D'autres matériaux peuvent être utilisés pour la couche d'isolant 107, parmi lesquels, non limitativement, le HfSiON ou le HfAlO (favorable aux performances du point mémoire 3).

Pour du HfO₂, on peut par exemple envisager une épaisseur de 10 nm de la couche d'isolant 107 pour une différence de potentiel de 3V, ou une épaisseur de 3nm pour une différence de potentiel d'au plus 1V.

La couche 107 aura une épaisseur et un matériau appropriés, de façon connue en soi, pour permettre la formation d'un filament conducteur d'une cellule mémoire OxRAM. L'épaisseur de la couche 107 déposée sur le substrat 100 caractérise l'épaisseur de l'isolant de grille du transistor 2. L'épaisseur de la couche 107 déposée sur les flancs de la gorge 33 caractérise l'épaisseur du filament conducteur de la cellule mémoire OxRAM. Une couche 107 en HfO₂ aura de préférence une épaisseur comprise entre 1 et 10nm (et de préférence entre 3 et 5nm).

La figure 14 illustre une variante du procédé de fabrication, dans laquelle l'épaisseur de la couche d'isolant 107 formée est supérieure au niveau du point mémoire 3 par rapport au transistor 2. Le procédé de formation de la couche d'isolant 107 selon cette variante peut comprendre une première étape de dépôt pleine plaque de matériau isolant avec une première épaisseur t1. Lors d'une deuxième étape, la zone du point mémoire 3 est masquée et le dépôt d'isolant est retiré par gravure dans la zone du transistor 2. Après retrait du masquage du point mémoire 3, le point mémoire 3 reste recouvert par une couche d'isolant d'une épaisseur t1. Lors d'une troisième étape, un dépôt de matériau isolant est réalisé pleine plaque avec une épaisseur t2. La couche d'isolant 107 formée présente alors une épaisseur t2 au niveau du transistor 2, et une épaisseur t1+t2 au niveau du point mémoire 3. L'épaisseur de la couche d'isolant 107 étant définie dans les différentes zones par des étapes de dépôt pleine plaque, elle peut aisément être obtenue industriellement avec une grande précision.

Cette variante illustre la possibilité de disposer d'épaisseurs différentes de la couche 107 pour le transistor 2 ou le point mémoire 3, en fonction de leurs contraintes de dimensionnement respectives. On peut bien entendu également envisager que l'épaisseur de la couche 107 pour le transistor 2 soit supérieure à celle du point mémoire 3.

La figure 15 illustre la poursuite du procédé de fabrication correspondant à la variante de la figure 13. Au stade illustré à la figure 15, on a procédé à la formation d'une couche de matériau conducteur 109 sur la couche 107. La couche de matériau conducteur 109 formée recouvre la zone du transistor 2 et la zone du point mémoire 3. La couche de matériau conducteur 109 recouvre ici la face supérieure de la couche 107 et les flancs des gorges 23 et 33, ainsi que le fond des gorges 23 et 33. Les gorges 23 et 33 ne sont pas intégralement remplies par la couche 109.

La couche de matériau conducteur 109 est ici formée par un dépôt pleine plaque. La couche de matériau conducteur 109 peut par exemple être déposée par un procédé PVD (dépôt physique en phase vapeur) ou CVD (dépôt chimique en phase vapeur). De tels procédés de dépôt permettent typiquement de former une couche 109 dont l'épaisseur sur les faces horizontales est supérieure à celle des faces verticales. L'épaisseur du dépôt de la couche 109 sur les faces latérales des gorges 23 et 33 est par exemple typiquement comprise entre 3 et 10 nm, et de préférence entre 3 et 6 nm, en particulier pour favoriser le fonctionnement du point mémoire 3. On peut également envisager un dépôt ALD pour la couche 109.

Le matériau choisi pour la couche 109 peut par exemple être du TiN ou du TaN. Ce matériau est par exemple choisi pour présenter un travail de sortie approprié pour la grille du transistor 2, et pour former une électrode d'un point mémoire OxRam 3.

La figure 16 illustre la poursuite du procédé de fabrication correspondant à la variante de la figure 14. La couche de matériau conducteur 109 est ici formée sur une couche d'isolant 107 présentant des épaisseurs distinctes au niveau du transistor 2 et du point mémoire 3.

Indépendamment du procédé de formation de la couche d'isolant 107, l'épaisseur de la couche de matériau conducteur 109 formée peut être différente au niveau du transistor 2 et du point mémoire 3. Par exemple, pour obtenir une épaisseur de la couche 109 au niveau du point mémoire 3 supérieure à son épaisseur au niveau du transistor 2, on peut réaliser une première étape de dépôt pleine plaque de matériau conducteur avec une épaisseur (épaisseur sur les faces verticales) t3. Lors d'une deuxième étape, la zone du point mémoire 3 est masquée et le dépôt de matériau conducteur est retiré par gravure dans la zone du transistor 2. Après retrait du masquage du point mémoire 3, le point mémoire 3 reste recouvert par une couche de matériau conducteur d'une épaisseur t3. Lors d'une quatrième étape, un dépôt du matériau conducteur est réalisé pleine plaque avec une épaisseur t4 (épaisseur sur les faces verticales). La couche de matériau conducteur 109 formée présente alors une épaisseur t3 au niveau du transistor 2, et une épaisseur t3+t4 au niveau du point mémoire 3. L'épaisseur de la couche de matériau conducteur 109 étant définie dans les différentes zones par des étapes de dépôt pleine plaque, elle peut aisément être obtenue industriellement avec une grande précision. L'épaisseur de la couche de matériau conducteur 109 est avantageusement comprise entre 2 et 20nm.

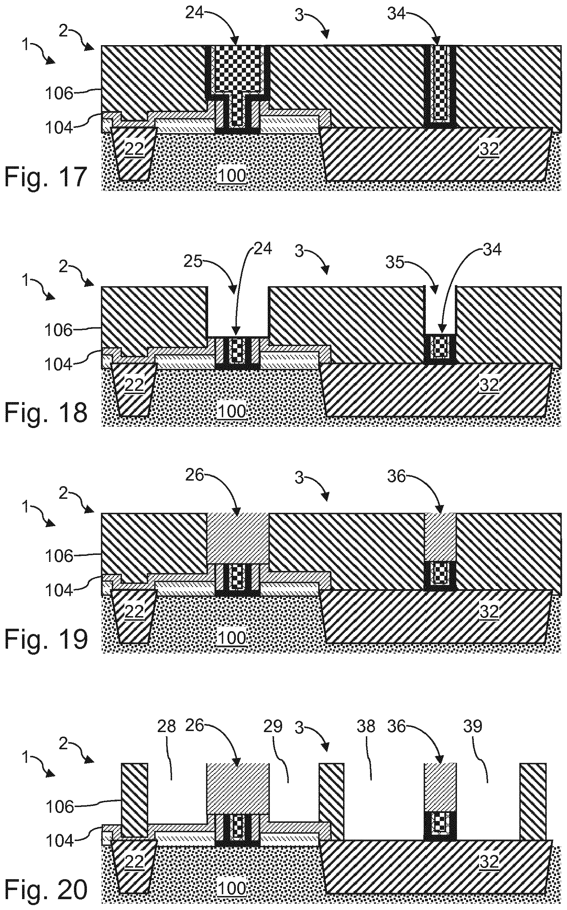

La figure 17 illustre la poursuite du procédé de fabrication correspondant à la variante de la figure 15. Au stade illustré à la figure 17, on a procédé au dépôt de métal sur la couche 109, de façon à remplir les gorges 23 et 33 par des plots métalliques 24 et 34 respectivement. Le métal déposé pour former les plots 24 et 34 est typiquement du Tungstène. On peut également envisager de façon non limitative de former les plots avec du Cuivre, du Cobalt ou du WSi. Un polissage mécano chimique a ici ensuite été réalisé et a été interrompu après avoir découvert la couche 106, qui sert alors de couche d'arrêt au polissage mécano chimique.

Au stade illustré à la figure 18, on a procédé à la formation de gorges 25 et 35 dans la couche 106. Les gorges 25 et 35 sont formées respectivement par retrait de la partie supérieure des plots 24 et 34 et retrait de la partie supérieure des couches 107 et 109. Ces retraits sont typiquement réalisés par une gravure de type gravure plasma (RIE pour Reactive Ion Etching, ou ICP pour Inductively Coupled Plasma en langue anglaise). Dans le cas où les tranchées 24 et 34 sont en W, des gravures à base des gaz suivants : BCl₃, Cl₂, SF6, Ar, N2H2, O₂ peuvent être envisagées. Ces retraits sont interrompus par exemple à l'expiration d'une temporisation, de façon à former des gorges 25 et 35 suffisamment profondes pour former des bouchons suffisamment épais à une étape ultérieure. La couche 104 est ici découverte au fond de la gorge 25.

Au stade illustré à la figure 19, on a procédé à la formation de bouchons 26 et 36 remplissant les gorges 25 et 35 respectivement. Les bouchons 26 et 36 sont typiquement formés par dépôt d'un matériau isolant, par exemple du nitrure de silicium. La formation des bouchons a ici été suivie d'une étape de polissage mécano chimique jusqu'à découvrir la surface supérieure de la couche 106 (qui sert de couche d'arrêt au polissage mécano-chimique). Les bouchons 26 et 36 formés servent pour une protection ultérieure des matériaux qu'ils recouvrent, en particulier l'empilement de grille du transistor 2 et l'isolant et une électrode du point mémoire 3.

Au stade illustré à la figure 20, on a réalisé une photolithographie pour définir des zones de contact de part et d'autre des bouchons 26 et 36. Ainsi, seules des parties de la couche 106 à l'aplomb des tranchées d'isolation 22 et 32 sont masquées. On a ensuite procédé à une étape de gravure des zones non masquées de la couche 106, jusqu'à découvrir la couche 104 et la tranchée d'isolation 32 de part et d'autre des bouchons 26 et 36. Des gorges 28 et 29 sont ainsi ménagées de part et d'autre du bouchon 26 et des gorges 38 et 39 sont ménagées de part et d'autre du bouchon 36. L'étape de gravure est typiquement réalisée de façon sélective par rapport au matériau des bouchons 26 et 36 (par exemple par une attaque d'oxyde) ou réalisée de façon anisotrope, de sorte que les zones gravées de part et d'autre des bouchons 26 et 36 sont auto alignées. Un tel auto alignement (les contacts obtenus sont usuellement désignés par SAC pour Self Aligned Contacts en langue anglaise) permet de garantir une compacité optimale du circuit intégré 1 formé, sans être limité par des dimensions de lithographie.

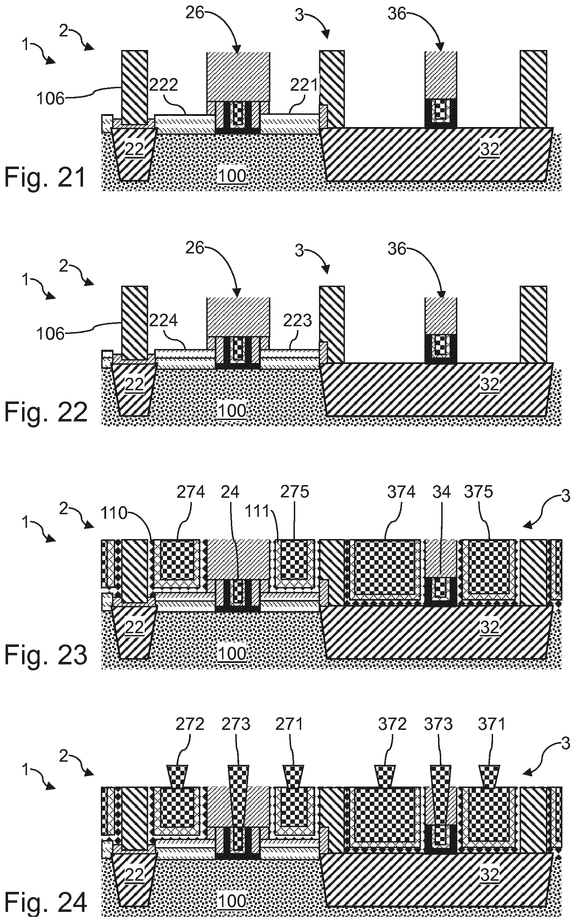

Au stade illustré la figure 21, on a retiré la couche 104 de part et d'autre du bouchon 26, jusqu'à découvrir les éléments semi-conducteurs 222 et 221. Le retrait de la couche 104 est par exemple réalisé par une gravure anisotrope.

Au stade illustré à la figure 22, on a avantageusement procédé à la silicidation des éléments semi-conducteurs 221 et 222 de part et d'autre du bouchon 26. La silicidation comprend typiquement un dépôt de métal de type Ni ou NiPt par exemple, un recuit, puis un retrait chimique du métal n'ayant pas réagi, et généralement une nouvelle étape de recuit. Des éléments semi-conducteurs siliciurés 223 et 224 sont ainsi formés de part et d'autre du bouchon 226. La silicidation peut être réalisée de façon à former des éléments 223 et 224 en NiSi ou NiPtSi par exemple. Avantageusement, la silicidation est réalisée sur une épaisseur de 5 à 15nm.

Au stade illustré à la figure 23, on a procédé à un dépôt d'une couche métallique 110 sur les éléments siliciurés 223 et 224, et sur la tranchée d'isolation 32, ainsi que sur les flancs des gorges 28,29 et 38,39 ménagées respectivement de part et d'autre des bouchons 26 et 36. Le métal déposé est typiquement du titane. Le Titane favorise une bonne fixation sur les surfaces sur lesquelles il est déposé. L'épaisseur de métal déposée sur les flancs des gorges peut avantageusement être comprise entre 2 et 15nm. L'épaisseur de métal déposée sur le fond des gorges peut avantageusement être comprise entre 2 et 15nm. La couche métallique 110 est avantageusement déposée par un procédé conforme (de type ALD ou CVD).

On a ensuite procédé à un dépôt d'une couche d'alliage métallique conductrice 111 sur la couche métallique 110. La couche d'alliage métallique 111 inclut typiquement du TiN. L'épaisseur de la couche 111 déposée sur les flancs des gorges peut avantageusement être comprise entre 3 et 10nm. L'épaisseur de la couche 111 déposée sur le fond des gorges peut avantageusement être comprise entre 3 et 10nm. La couche 111 est avantageusement déposée par un procédé conforme (ALD, ou CVD).

On a ensuite procédé au dépôt de métal sur la couche 111, de façon à remplir les gorges par des plots métalliques 274 et 275 de part et d'autre du bouchon 26, et des plots métalliques 374 et 375 de part et d'autre du bouchon 36. Le métal déposé pour former les plots est typiquement du Tungstène. On peut également envisager de façon non limitative de l'Aluminium, du Cobalt, du Cuivre, du Platine ou du WSi. Un polissage mécano chimique a ici ensuite été réalisé et a été interrompu après avoir atteint les bouchons 26 et 36.

La présence d'une éventuelle couche de TiN entre la couche métallique 110 et des plots de tungstène a le rôle de couche d'accroche pour le tungstène des plots et de barrière de diffusion face au fluor, fréquemment utilisé comme gaz précurseur lors du dépôt de tungstène.

Au stade illustré à la figure 24, on a formé des contacts métalliques d'interconnexion 273,373,272,271,372,371 respectivement avec les plots 24,34, 274,275,374,375. Les contacts métalliques 272, 271 et 273 sont respectivement en contact avec la source, le drain et la grille du transistor 2.

En pratique, le point mémoire 3 comporte une première cellule mémoire entre le plot 34 et le plot 374 d'une part et une autre cellule mémoire entre les plots 34 et les plots 375.

En disposant d'un plot 275 du transistor 2 dissocié du plot 374 du point mémoire 3, on peut éventuellement dissocier leur fonctionnement et éventuellement éviter que le fonctionnement de l'un ne dégrade le fonctionnement de l'autre.

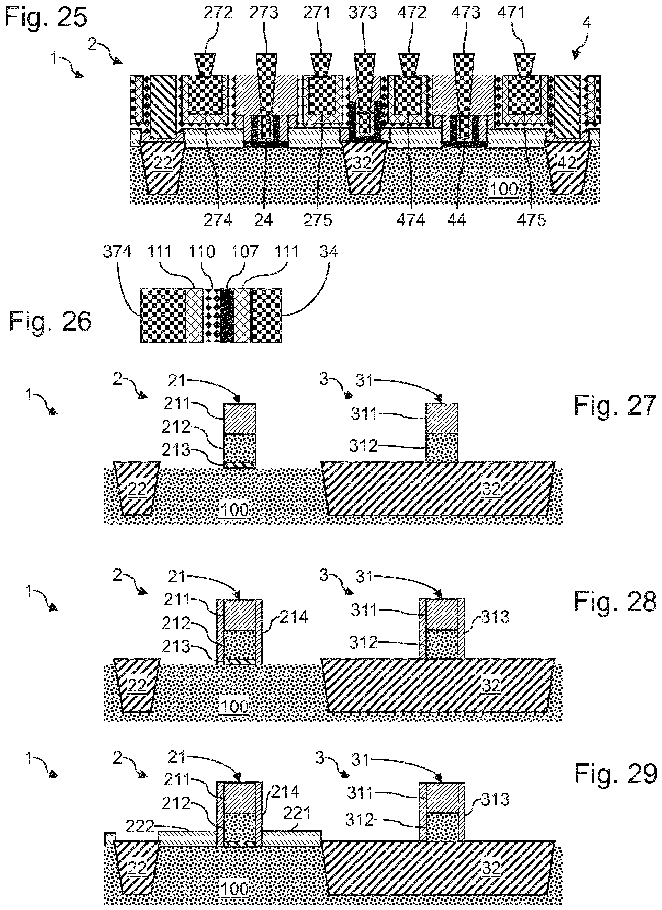

La figure 26 est une vue en coupe schématique selon un plan parallèle au substrat 100, illustrant la succession de couches mise en oeuvre pour la formation d'une cellule OxRAM du point mémoire 3.

En formant le point mémoire 3 dans la couche d'avant métallisation, on peut bénéficier d'un pas (pitch en langue anglaise) très réduit disponible pour une telle couche d'avant métallisation, afin de réduire la surface du substrat 100 recouverte par le point mémoire 3. Un pas de 90 nm, ou de 64 nm peut par exemple être utilisé.

Le procédé est basé sur une formation de grille en dernier, qui permet de former un dépôt d'isolant sur un flanc d'une tranchée, et ainsi de réaliser une couche d'isolant pour un filament conducteur horizontal.

Dans un procédé de fabrication selon l'invention, un très grand nombre d'étapes et de matériaux sont communs pour la formation du transistor 2 et la formation du point mémoire 3. Ainsi, le procédé de fabrication est sensiblement simplifié et son coût de revient est particulièrement réduit.

Dans le procédé illustré, le point mémoire 3 est avantageusement (mais non nécessairement) formé sur une tranchée d'isolation afin de tirer parti d'une partie de circuit intégré nécessaire pour isoler des composants entre eux mais usuellement peu utilisée dans une couche d'avant métallisation. La densité d'intégration du circuit intégré 1 peut ainsi être encore accrue.

La figure 25 illustre une variante de circuit intégré 1 pouvant être obtenue par un procédé de fabrication similaire. Cette variante vise à augmenter la densité d'intégration du circuit intégré 1 en utilisant des électrodes communes pour des transistors de sélection 2 et 4 et deux cellules mémoire du point mémoire 3.

Le transistor 2 de la figure 25 présente sensiblement la même structure que le transistor 2 de la figure 24. Le transistor 4 présente sensiblement la même structure que le transistor 2. Le transistor 4 est ménagé entre une tranchée d'isolation 42 et la tranchée d'isolation 32. Le transistor 4 comporte un plot métallique de grille 44, un plot métallique de drain 474 et un plot métallique de source 475. Les plots 44,474 et 475 sont connectés à des contacts métalliques 473,472 et 471 respectivement. Les contacts métalliques 471, 472 et 473 sont respectivement en contact avec la source, le drain et la grille du transistor 4.

Une première cellule du point mémoire 3 partage une électrode commune avec le transistor 2, par le plot 275. Une deuxième cellule du point mémoire 3 partage une électrode commune avec le transistor 4, par le plot 474.

La figure 27 est une vue en coupe transversale d'un circuit intégré 1 au début d'un procédé de fabrication selon un deuxième mode de réalisation de l'invention. Au début de ce procédé de fabrication, on fournit un substrat semi-conducteur 100, identique à celui de la figure 1. Des tranchées d'isolation 22 et 32 identiques à celle de la figure 1 sont formées dans le substrat 100.

Une grille factice 21 (dummy gate en langue anglaise) d'un transistor 2 est disposée sur le substrat 100, entre les tranchées d'isolation 22 et 32. La grille factice 21 comprend ici une partie isolante 213, un élément semi-conducteur 212 formé sur la partie isolante 213, et un élément isolant 211 formé sur l'élément semi-conducteur 212. La partie isolante 213 peut être réalisée dans le même matériau que les tranchées d'isolation 22 et 32. La partie isolante 213 peut par exemple présenter une épaisseur comprise entre 2 et 6 nm. L'élément semi-conducteur 212 et l'élément isolant 211 peuvent présenter les mêmes matériaux et même épaisseur que dans l'exemple de la figure 1.

Une grille factice 31 d'un point mémoire 3 est ici avantageusement disposée sur la tranchée d'isolation 32. La grille factice 31 comprend ici un élément semi-conducteur 312 formé sur la tranchée d'isolation 32. La grille factice 31 peut être identique à celle décrite en référence à la figure 1.

Au stade illustré à la figure 28, une couche de matériau isolant a été déposée de façon à former des espaceurs 214 et 313 de part et d'autre des grilles factices 21 et 31 respectivement. Ce matériau peut être un matériau tel que le nitrure de silicium, ou un matériau de type lowK tel que le SiCBN ou le SiOCN. L'épaisseur des espaceurs 214 et 313 formés de part et d'autre des grilles factices 21 et 31 est par exemple comprise entre 5 et 7 nm, typiquement 6 nm.

Le dépôt du matériau isolant des espaceurs 214 et 313 peut être réalisé pleine plaque par exemple par un procédé ALD, puis suivi par une étape de gravure (par exemple gravure anisotrope) de façon à retirer ce matériau isolant des surfaces supérieures respectives du substrat 100 et des tranchées d'isolation 22 et 32.

Au stade illustré à la figure 29, des éléments semi-conducteurs 222 et 221 sont avantageusement formés de part et d'autre de la grille factice 21, sur le semi-conducteur du substrat 100, entre les tranchées d'isolation 22 et 32. Les éléments semi-conducteurs 222 et 221 sont typiquement formés sur une épaisseur de 10 à 35 nm. Les éléments semi-conducteurs 222 et 221 sont typiquement formés par épitaxie sur le semi-conducteur du substrat 100. Les éléments 222 et 221 sont typiquement obtenus par une croissance par épitaxie sélective de silicium sur du silicium cristallin du substrat 100. Ils peuvent également être obtenus par croissance sélective de SiGe. Les éléments 221 et 222 peuvent faire l'objet d'un dopage par une étape ultérieure d'implantation, non détaillée ici, ou bien par un dopage in-situ lors de l'étape d'épitaxie. Préalablement à l'étape d'épitaxie, un renfoncement est avantageusement ménagé dans le matériau du substrat 100, par exemple pour mettre le canal sous contrainte d'un substrat massif 100.

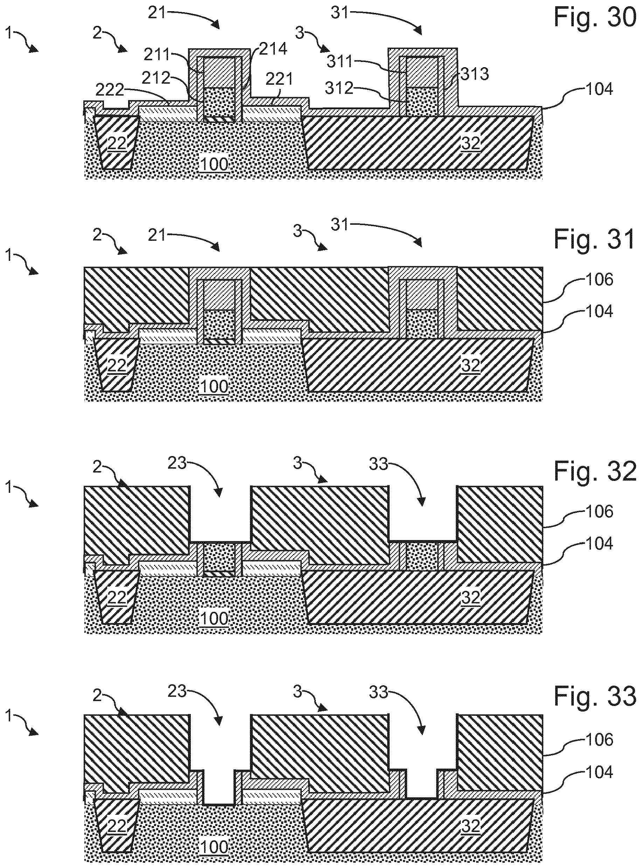

Au stade illustré à la figure 30, une couche 104 de matériau isolant est déposée de façon à accroître l'épaisseur des espaceurs de part et d'autre des grilles factices 21 et 31. La couche 104 est par exemple déposée pleine plaque, par exemple par un procédé ALD (dépôt par couche atomique). La couche 104 peut être réalisée en un matériau tel que le nitrure de silicium, ou en des matériaux de type lowK tels que le SiCBN ou le SiOCN. L'épaisseur totale des espaceurs obtenus après dépôt de la couche 104 est avantageusement comprise entre 5 et 15nm.

Au stade illustré à la figure 31, on a réalisé une encapsulation du circuit intégré 1 dans une couche d'isolant 106. L'encapsulation est typiquement réalisée pleine plaque au moyen d'un oxyde de silicium. Un polissage mécano chimique a ici ensuite été réalisé et a été stoppé après avoir atteint la couche 104.

Au stade illustré à la figure 32, on a procédé à la formation de gorges 23 et 33 dans la couche d'isolant 106, par retrait des éléments 211 et 311, de la partie supérieure de la couche 104 et d'une partie des espaceurs 214 et 313, jusqu'à atteindre respectivement les éléments semi-conducteurs 212 et 312. Un retrait de nitrure de silicium jusqu'à atteindre les éléments 212 et 312 est par exemple réalisé par gravure chimique humide avec du H₃PO₄ à chaud (par exemple entre 150 et 160°C). Dans le cas particulier d'éléments 212 et 312 en Silicium et d'une couche 106 en oxyde de Silicium, une telle gravure s'avère particulièrement sélective.

Au stade illustré à la figure 33, on a procédé au retrait des éléments 212 et 312. Les gorges 23 et 33 atteignent alors respectivement la partie de couche d'arrêt 213 et la tranchée d'isolation profonde 32. Le retrait des éléments 212 et 312 peut par exemple être réalisé par une gravure chimique avec du TMAH (Tetramethylammonium hydroxide) ou du NH₄OH.

Pour atteindre la configuration illustrée à la figure 33, on a procédé au retrait de la partie isolante 213. La gorge 23 atteint alors le substrat 100. Ce retrait est par exemple effectué par une gravure chimique à l'acide fluorhydrique. Une telle gravure chimique permet en outre de préparer la surface du substrat 100 pour une étape de dépôt ultérieure.

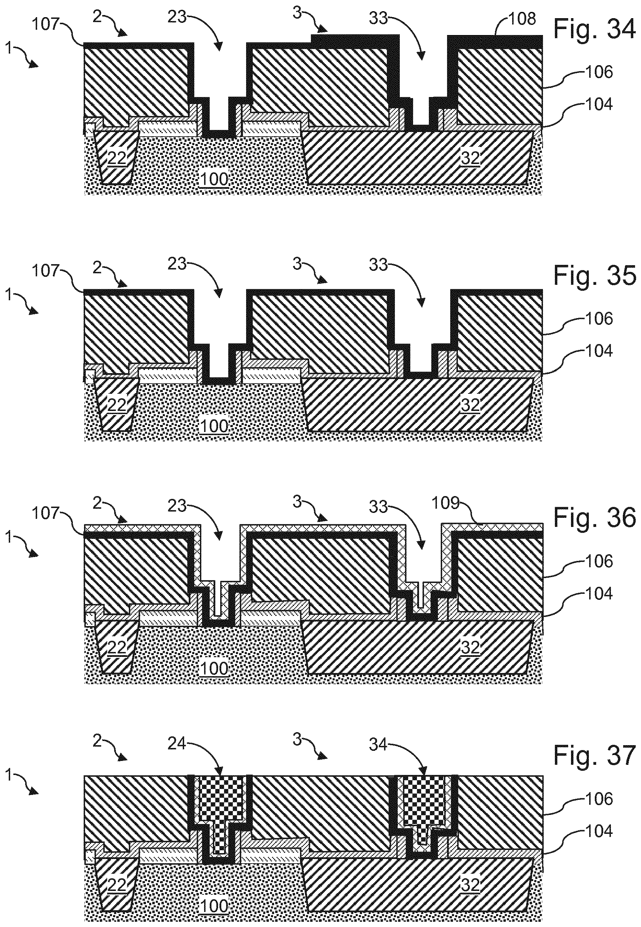

Au stade illustré à la figure 34, on a procédé à la formation d'une couche d'isolant 107 recouvrant la zone du transistor 2 et la zone du point mémoire 3. La couche d'isolant 107 recouvre ici la face supérieure de la couche 106, les flancs des gorges 23 et 33, et respectivement le substrat 100 et la tranchée d'isolation 32 au fond des gorges 23 et 33. Les gorges 23 et 33 ne sont pas intégralement remplies par la couche d'isolant 107. La couche d'isolant 107 est ici formée par un dépôt pleine plaque. La couche d'isolant 107 peut par exemple être déposée par un procédé de type ALD, ce qui permet d'obtenir une épaisseur homogène sur des faces verticales et des faces horizontales lors d'une même étape de dépôt.

Le matériau choisi pour la couche d'isolant 107 peut être identique à celui décrit pour le procédé du premier mode de réalisation, compatible à la fois pour former un isolant de grille pour le transistor 2 et pour former l'isolant du filament conducteur du point mémoire 3.

La couche 107 aura une épaisseur et un matériau appropriés, de façon connue en soi, pour permettre la formation d'un filament conducteur d'une cellule mémoire OxRAM. L'épaisseur de la couche 107 déposée sur le substrat 100 caractérise l'épaisseur de l'isolant de grille du transistor 2. L'épaisseur de la couche 107 déposée sur les flancs de la gorge 33 caractérise l'épaisseur du filament conducteur de la cellule mémoire OxRAM. Une couche 107 en HfO₂ aura de préférence une épaisseur comprise entre 1 et 10nm (et de préférence entre 3 et 5nm).

La figure 34 illustre une variante du procédé de fabrication, dans laquelle l'épaisseur de la couche d'isolant 107 formée est supérieure au niveau du point mémoire 3 par rapport au transistor 2. Le procédé de formation de la couche d'isolant 107 selon cette variante peut comprendre une première étape de dépôt pleine plaque de matériau isolant avec une première épaisseur t1. Lors d'une deuxième étape, la zone du point mémoire 3 est masquée et le dépôt d'isolant est retiré par gravure dans la zone du transistor 2. Après retrait du masquage du point mémoire 3, le point mémoire 3 reste recouvert par une couche d'isolant d'une épaisseur t1. Lors d'une troisième étape, un dépôt de matériau isolant est réalisé pleine plaque avec une épaisseur t2. La couche d'isolant 107 formée présente alors une épaisseur t2 au niveau du transistor 2, et une épaisseur t1+t2 au niveau du point mémoire 3. L'épaisseur de la couche d'isolant 107 étant définie dans les différentes zones par des étapes de dépôt pleine plaque, elle peut aisément être obtenue industriellement avec une grande précision.

Cette variante illustre la possibilité de disposer d'épaisseurs différentes de la couche 107 pour le transistor 2 ou le point mémoire 3, en fonction de leurs contraintes de dimensionnement respectives. On peut bien entendu également envisager que l'épaisseur de la couche 107 pour le transistor 2 soit supérieure à celle du point mémoire 3.

La figure 35 illustre une variante du procédé de fabrication dans laquelle l'épaisseur de la couche d'isolant 107 formée est homogène au niveau du point mémoire 3 et au niveau du transistor 2.

La figure 36 illustre la poursuite du procédé de fabrication correspondant à la variante de la figure 35. Au stade illustré à la figure 36, on a procédé à la formation d'une couche de matériau conducteur 109 sur la couche 107. La couche de matériau conducteur 109 formée recouvre la zone du transistor 2 et la zone du point mémoire 3. La couche de matériau conducteur 109 recouvre ici la face supérieure de la couche 107 et les flancs des gorges 23 et 33, ainsi que le fond des gorges 23 et 33. Les gorges 23 et 33 ne sont pas intégralement remplies par la couche 109.

La couche de matériau conducteur 109 est ici formée par un dépôt pleine plaque. La couche de matériau conducteur 109 peut par exemple être déposée par un procédé PVD (dépôt physique en phase vapeur) ou CVD (dépôt chimique en phase vapeur) ou ALD. Le matériau et/ou l'épaisseur de la couche 109 peuvent être identiques à ceux du procédé selon le premier mode de réalisation.

Au stade illustré à la figure 37, on a procédé au dépôt de métal sur la couche 109, de façon à remplir les gorges 23 et 33 par des plots métalliques 24 et 34 respectivement. Le métal déposé pour former les plots 24 et 34 peut être identique à celui décrit pour le procédé selon le premier mode de réalisation. Un polissage mécano chimique a ici ensuite été réalisé et a été interrompu après avoir découvert la couche 106.

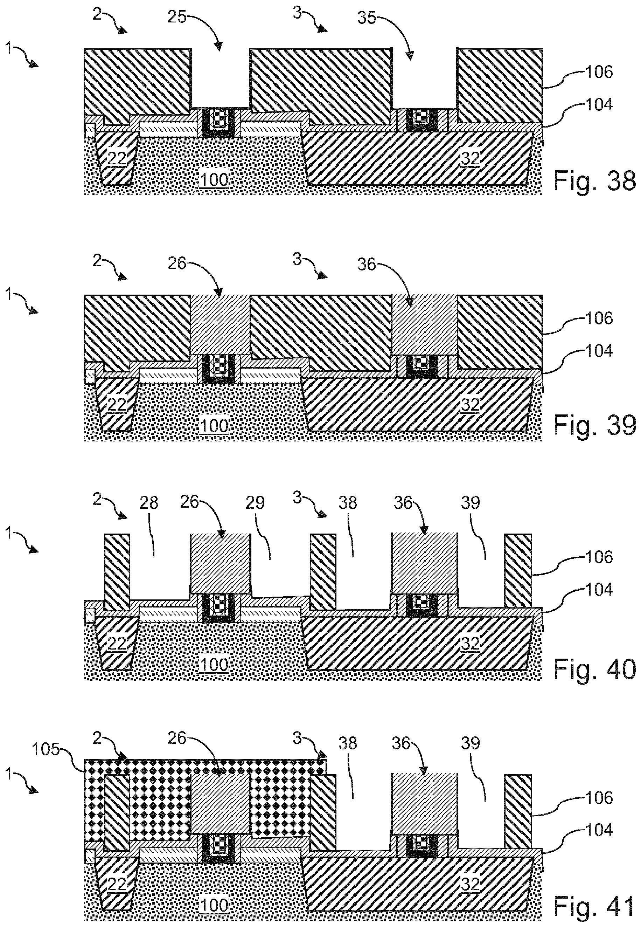

Au stade illustré à la figure 38, on a procédé à la formation de gorges 25 et 35 dans la couche 106. Les gorges 25 et 35 sont formées respectivement par retrait de la partie supérieure des plots 24 et 34 et retrait de la partie supérieure des couches 107 et 109. Ces retraits sont typiquement réalisés par une gravure de type gravure plasma (RIE pour Reactive Ion Etching, ou ICP pour Inductively Coupled Plasma en langue anglaise). Dans le cas où les tranchées 24 et 34 sont en W, des gravures à base des gaz suivants : BCl₃, Cl₂, O₂ peuvent être envisagées. Ces retraits sont interrompus par exemple à l'expiration d'une temporisation, de façon à former des gorges 25 et 35 suffisamment profondes pour former des bouchons suffisamment épais à une étape ultérieure. La couche 104 est alors découverte au fond de la gorge 25.

Au stade illustré à la figure 39, on a procédé à la formation de bouchons 26 et 36 remplissant les gorges 25 et 35 respectivement. Les bouchons 26 et 36 sont typiquement formés par dépôt d'un matériau isolant, par exemple du nitrure de silicium. La formation des bouchons a ici été suivie d'une étape de polissage mécano chimique jusqu'à découvrir la surface supérieure de la couche 106. Les bouchons 26 et 36 formés servent pour une protection ultérieure des matériaux qu'ils recouvrent, en particulier l'empilement de grille du transistor 2 et l'isolant et une électrode du point mémoire 3.

Au stade illustré à la figure 40, on a réalisé une photolithographie pour définir des zones de contact de part et d'autre des bouchons 26 et 36. Ainsi, seules des parties de la couche 106 à l'aplomb des tranchées d'isolation 22 et 32 sont masquées. On a ensuite procédé à une étape de gravure des zones non masquées de la couche 106, jusqu'à découvrir la couche 104 de part et d'autre des bouchons 26 et 36. Des gorges 28 et 29 sont ainsi ménagées de part et d'autre du bouchon 26 et des gorges 38 et 39 sont ménagées de part et d'autre du bouchon 36. L'étape de gravure est typiquement réalisée de façon sélective par rapport au matériau des bouchons 26 et 36 (par exemple par une attaque d'oxyde), de sorte que les zones gravées de part et d'autre des bouchons 26 et 36 sont auto alignées.

Au stade illustré à la figure 41, un masquage 105 a été défini pour recouvrir la grille factice 21 et la couche 104 entre les tranchées d'isolation 22 et 32. Le masquage 105 remplit notamment les tranchées d'isolation 28 et 29. Le masquage 105 a été retiré par photolithographie pour découvrir les zones des points mémoire 3. Le masquage 105 n'a ainsi été conservé que sur les zones de transistor 2.

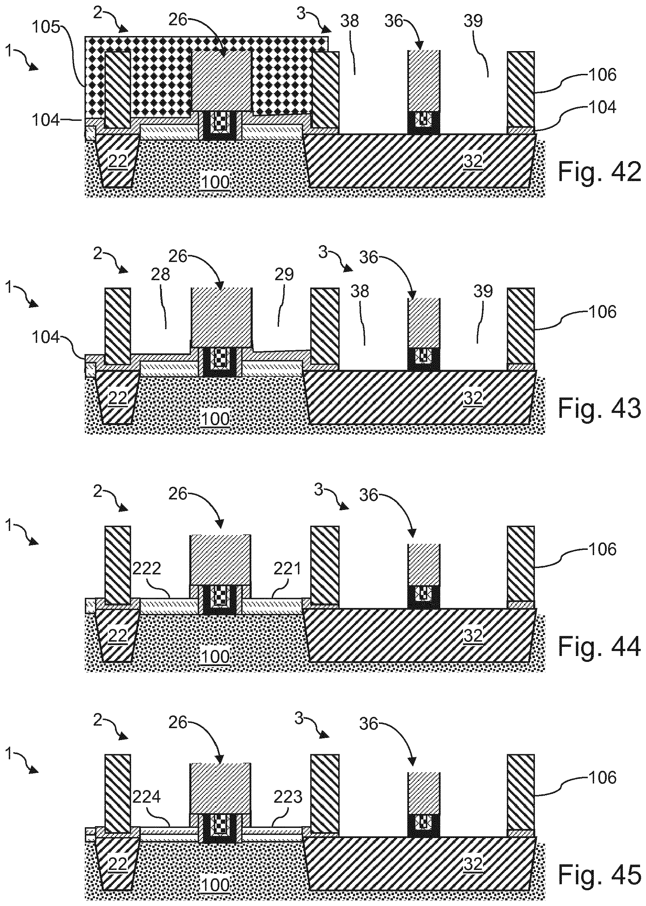

Au stade illustré à la figure 42, on a retiré la couche 104 de part et d'autre de la grille factice 31 et du bouchon 36 par gravure, par exemple par une gravure anisotrope. La tranchée d'isolation 32 est ainsi découverte de part et d'autre de la grille factice 31. Les espaceurs sont retirés de part et d'autre de la grille factice et du bouchon 36.

Au stade illustré à la figure 43, le masquage 105 est retiré de façon connue en soi, de façon à découvrir la couche d'arrêt 104 restant dans la zone du transistor 2.

Selon une variante non illustrée, à la suite du stade illustré à la figure 40, on peut réaliser un dépôt d'isolant pleine plaque, par exemple de l'oxyde de silicium, et par exemple par un procédé de type ALD. Par une photolithographie, on peut masquer la zone du transistor 2 et découvrir la zone du point mémoire 3. On peut ensuite réaliser une gravure de ce dépôt d'isolant dans la zone du point mémoire 3, jusqu'à atteindre la couche 104. Lorsque la couche d'isolant déposée est un oxyde de silicium, la gravure peut être de type gravure ionique réactive. Le masquage de la zone du transistor 2 peut être retiré ensuite. Ensuite, on peut retirer la couche 104 de part et d'autre de la grille factice 31 et du bouchon 36 par gravure, par exemple par une gravure à l'acide orthophosphorique. La tranchée d'isolation 32 est ainsi découverte de part et d'autre de la grille factice 31 et du bouchon 36. Les espaceurs sont retirés de part et d'autre de la grille factice et du bouchon 36. Cette étape de retrait par gravure peut également être réalisée avec un mélange de type HFEG (HF = acide fluorhydrique, EG = Ethylene Glycol), afin de retirer à la fois la couche 104 comme décrit précédemment, et retirer également une partie de l'oxyde de silicium déposé auparavant dans la zone du transistor 2.

Au stade illustré la figure 44, on a retiré la couche 104 de part et d'autre du bouchon 26, jusqu'à découvrir les éléments semi-conducteurs 222 et 221. Le retrait de la couche 104 est par exemple réalisé par une gravure anisotrope.

Au stade illustré à la figure 45, on a procédé à la silicidation des éléments semi-conducteurs 221 et 222 de part et d'autre du bouchon 26. La silicidation comprend typiquement un dépôt de métal de type Ni ou NiPt par exemple, un recuit, puis un retrait chimique du métal n'ayant pas réagi, et généralement une nouvelle étape de recuit. Des éléments semi-conducteurs siliciurés 223 et 224 sont ainsi formés de part et d'autre du bouchon 226. Ces éléments 223 et 224 peuvent présenter la même composition que dans le premier mode de réalisation. Avantageusement, la siliciuration est réalisée sur une épaisseur de 5 à 15nm.

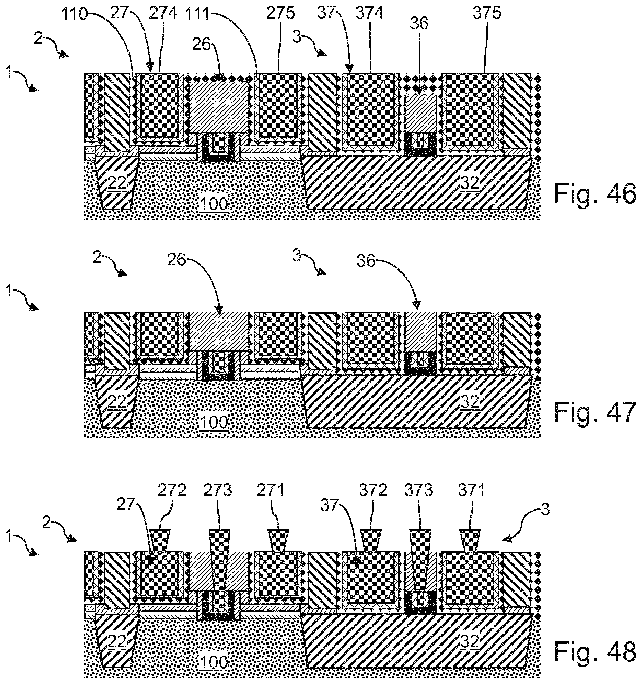

Au stade illustré à la figure 46, on a procédé à un dépôt d'une couche métallique 110 sur les éléments siliciurés 223 et 224, et sur la tranchée d'isolation 32, ainsi que sur les flancs des gorges 28,29 et 38,39 ménagées respectivement de part et d'autre des bouchons 26 et 36. Le métal déposé est typiquement du titane. L'épaisseur de métal déposée sur les flancs des gorges peut avantageusement être comprise entre être comprise entre 2 et 15nm. L'épaisseur de métal déposée sur le fond des gorges peut avantageusement être comprise entre être comprise entre 2 et 15nm. La couche métallique 110 est avantageusement déposée par un procédé de type CVD, afin de disposer d'une épaisseur similaire sur les parois horizontales et verticales.

On a ensuite procédé à un dépôt d'une couche d'alliage métallique conductrice 111 sur la couche métallique 110. La couche d'alliage métallique 111 inclut typiquement du TiN. L'épaisseur de la couche 111 déposée sur les flancs des gorges peut avantageusement être comprise entre 3 et 10nm. L'épaisseur de la couche 111 déposée sur le fond des gorges peut avantageusement être comprise entre 3 et 10nm. La couche 111 est avantageusement déposée par un procédé conforme (ALD, ou CVD).

On a ensuite procédé au dépôt de métal sur la couche 111, de façon à remplir les gorges par des plots métalliques 274 et 275 de part et d'autre du bouchon 26, et des plots métalliques 374 et 375 de part et d'autre du bouchon 36. Le métal déposé pour former les plots métalliques est typiquement du Tungstène. On peut également envisager de façon non limitative de l'Aluminium, du Cobalt, du Cuivre, du Platine ou du WSi.

Au stade illustré à la figure 47, un polissage mécano chimique a ici été réalisé et a été interrompu après avoir atteint les bouchons 26 et 36.

Au stade illustré à la figure 48, on a formé des contacts métalliques d'interconnexion 273,373,272,271,372,371 respectivement avec les plots 24,34, 274,275,374,375. Les contacts métalliques 272, 271 et 273 sont respectivement en contact avec la source, le drain et la grille du transistor 2.

En pratique, le point mémoire 3 comporte une première cellule mémoire entre le plot 34 et le plot 374 d'une part et une autre cellule mémoire entre les plots 34 et les plots 375.

Bien que non détaillé, le procédé de fabrication selon le deuxième mode de réalisation peut également être mis en oeuvre pour fabriquer des transistors et des cellules mémoire présentant des électrodes en commun, comme dans l'exemple illustré à la figure 25.

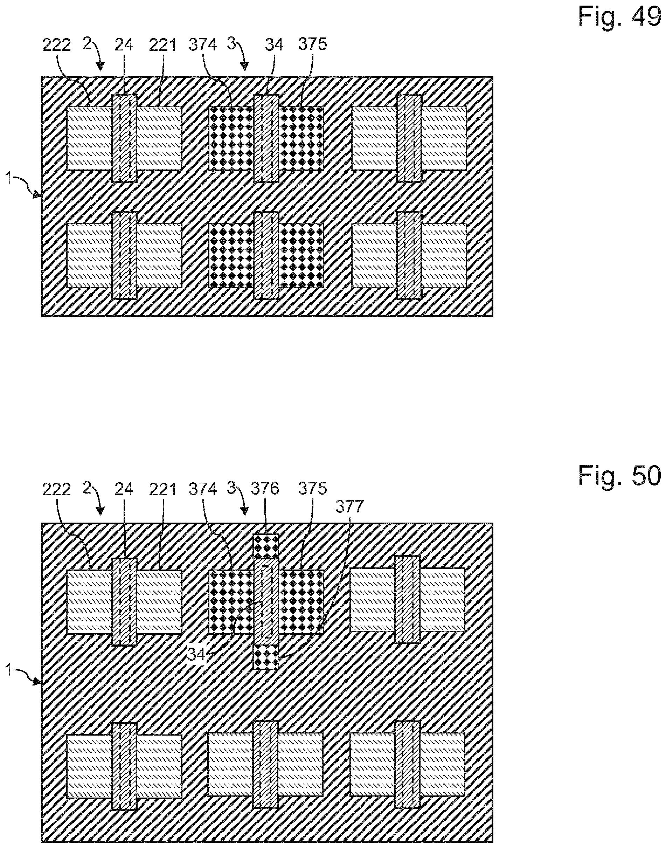

Comme détaillé dans les exemples précédents, un même point mémoire 3 permet de délimiter deux empilements horizontaux, pour former deux cellules mémoire. La figure 49 est une vue de dessus partielle d'un exemple de circuit intégré 1, illustrant un point mémoire 3 avec deux cellules formées de part et d'autre d'un plot conducteur 34, et des transistors de sélection 2 respectifs.

La vue de dessus illustrée à la figure 50 représente une variante de circuit intégré 1 dans lequel le point mémoire 3 comporte deux cellules mémoire de part et d'autre du plot 34 selon un premier axe, et deux cellules mémoire de part et d'autre du plot 34 selon un deuxième axe. Le point mémoire 3 comporte ainsi quatre cellules mémoires. Le plot 34 forme une première électrode commune à chacune de ces cellules mémoire, les plots 374 à 377 formant des plots de connexion respectifs pour ces cellules mémoire. Chaque cellule mémoire comporte un transistor de sélection respectif, les connexions avec ces transistors de sélection n'étant pas détaillées.

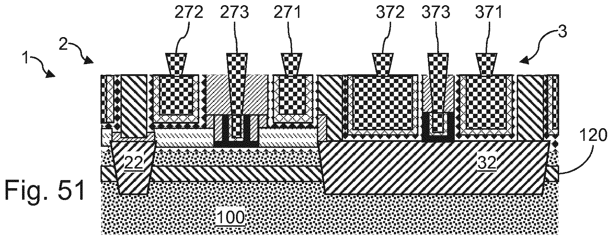

Bien que l'invention décrite dans les exemples précédents soit appliquée à des substrats de type massif, l'invention s'applique également à des substrats de type silicium sur isolant, comme dans l'exemple illustré à la figure 51. Une couche d'isolant enterrée 120 est intégrée dans le substrat 100. La couche d'isolant enterrée 120 peut par exemple être de type UTBOX. Des plans de masse polarisés peuvent être ménagés de façon connue en soi sous la couche d'isolant UTBOX. Le circuit intégré 1 peut par exemple être appliqué pour réaliser des transistors de type FDSOI. Que ce soit en technologie bulk (substrat massifs) ou SOI, les transistors peuvent être planaires ou encore tridimensionnels, avec une géométrie finFET ou triple grille (pour trigate en langue anglaise) par exemple.

Bien que l'invention décrite dans les exemples précédents comporte des éléments semi-conducteurs 221 et 222 formés avec une croissance par épitaxie, on peut également envisager de se dispenser de ces éléments 221 et 222 pour ménager les source et drain du transistor 2 uniquement dans le semi-conducteur du substrat 100.

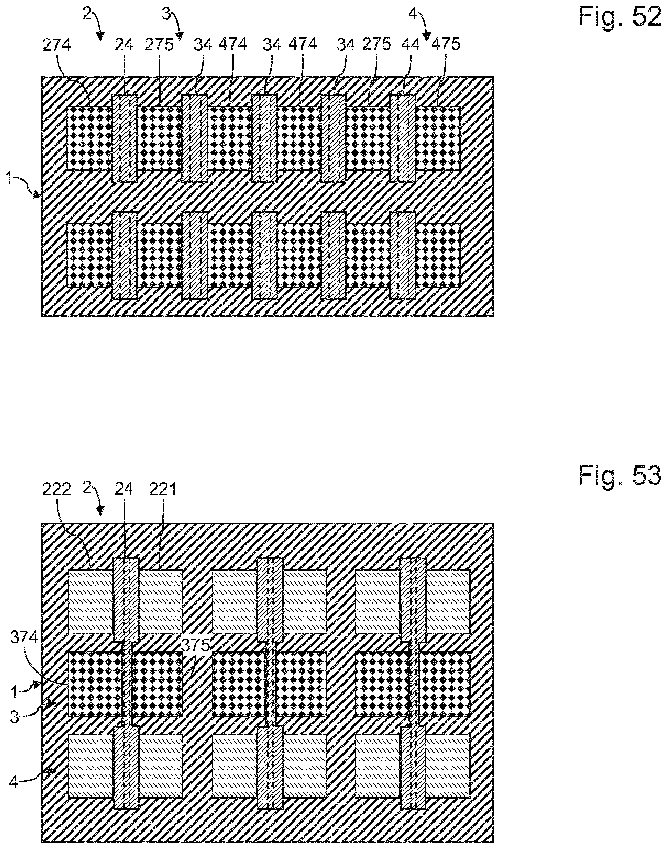

La vue de dessus illustrée à la figure 52 représente une variante de circuit intégré 1 permettant d'augmenter encore la densité d'intégration. Plusieurs points mémoire 3 comportent deux cellules de part et d'autre de plots 34. Plusieurs points mémoire comportent des plots communs 474. Des transistors de sélection 2 et 4 sont également connectés et comportent des plots 275 communs avec des cellules de points mémoire 3 d'extrémité.

La vue de dessus illustrée à la figure 53 représente une autre variante de circuit intégré 1 permettant d'optimiser la densité d'intégration. Plusieurs points mémoire 3 comportent deux cellules de part et d'autre de plots 24. Des transistors 2 et 4 sont disposés de part et d'autre de chaque point mémoire 3. Le plot 24 est utilisé comme plot commun pour la grille d'un transistor 2, la grille d'un transistor 4, et une électrode d'un point mémoire 3.

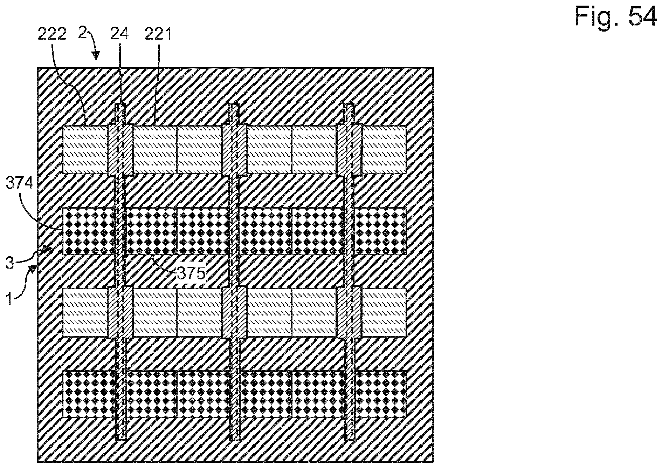

La vue de dessus illustré à la figure 54 représente une autre variante de circuit intégré 1 permettant d'optimiser la densité d'intégration, dans le cas particulier de transistors de type FinFET, c'est-à-dire des transistors à zone active tridimensionnelle. Le plot 24 est utilisé comme plot commun pour les grilles de plusieurs transistors 2, et pour les électrodes de plusieurs points mémoire 3.

## Revendications

1. Procédé de fabrication d'un circuit intégré (1) incluant au moins un transistor à effet de champ (2) et une cellule mémoire (3) de type OxRam, **caractérisé en ce qu'**il comprend les étapes de :
- fournir un substrat (100) incluant une couche de semi-conducteur, le substrat étant muni de première et deuxième grilles factices (21,31) et d'une couche d'encapsulation (106) dans laquelle lesdites grilles factices (21,31) sont disposées, au moins la première grille factice étant formée sur la couche de semi-conducteur du substrat ;
- retirer les première et deuxième grilles factices pour ménager des première et deuxième gorges (23,33) dans ladite couche d'encapsulation (106) ;
- déposer simultanément une couche d'isolant de grille (107) au moins dans le fond de la première gorge et sur une paroi latérale de la deuxième gorge ;
- former une électrode de grille (24) dudit transistor (2) dans la première gorge au-dessus de ladite couche d'isolant de grille, former des électrodes de source et de drain (274,275) dudit transistor de part et d'autre de ladite électrode de grille, former des première et deuxième électrodes de ladite cellule mémoire (374,34) de part et d'autre de ladite couche d'isolant de grille déposée sur une paroi latérale de la deuxième gorge.

2. Procédé de fabrication d'un circuit intégré (1) selon la revendication 1, comprenant la formation d'une paroi isolante disposée entre lesdites première et deuxième électrodes (374, 34) de la cellule mémoire (3), cette paroi isolante incluant ladite couche d'isolant de grille (107) déposée sur une paroi latérale de la deuxième gorge (33), et présentant une épaisseur dimensionnée pour former sélectivement un filament conducteur lors de l'application d'une différence de potentiel entre les première et deuxième électrodes.

3. Procédé de fabrication d'un circuit intégré (1) selon la revendication 2, comprenant en outre la formation d'une couche additionnelle d'isolant (108) dans ladite deuxième gorge (33) sur ladite couche d'isolant de grille (107), ladite couche additionnelle d'isolant étant incluse dans ladite paroi isolante disposée entre lesdites première et deuxième électrodes (374,34).

4. Procédé de fabrication d'un circuit intégré (1) selon l'une quelconque des revendications précédentes, dans laquelle ladite couche d'isolant de grille déposée (107) inclut un matériau choisi dans le groupe comprenant le Hf02, le HfSiON, le HfAlO, le TiOₓ, le Al₂O₃ ou le NiO.

5. Procédé de fabrication d'un circuit intégré (1) selon l'une quelconque des revendications précédentes, dans lequel la formation des électrodes de source, de drain et de ladite première électrode de la cellule mémoire inclut la formation de gorges additionnelles (28, 29, 38) dans la couche d'encapsulation (106), de part et d'autre de la première gorge (23) et sur le côté de la deuxième gorge (33).

6. Procédé de fabrication d'un circuit intégré selon la revendication 5, comprenant le dépôt d'une couche de protection (26,36) dans les première et deuxième gorges respectivement sur ladite électrode de grille (24) et ladite deuxième électrode (34) de la cellule mémoire, ladite couche de protection étant formée dans un matériau différent de la couche d'encapsulation, la formation desdites gorges additionnelles incluant une gravure auto alignée de la couche d'encapsulation (106) de part et d'autre de la couche de protection (26,36).

7. Procédé de fabrication d'un circuit intégré selon la revendication 5 ou 6, dans lequel la formation des électrodes de source, de drain et de ladite première électrode de la cellule mémoire inclut :
- la formation d'une couche de titane (110) sur les parois desdites gorges additionnelles ;
- la formation d'une couche de nitrure de titane (111) sur la couche de titane;
- le dépôt d'une couche métallique sur ladite couche de titane.

8. Procédé de fabrication selon l'une quelconque des revendications précédentes, dans lequel ladite première électrode formée pour ladite cellule mémoire (3) forme également une desdites électrodes de source ou de drain formée pour ledit transistor (2).

9. Procédé de fabrication selon l'une quelconque des revendications précédentes, dans lequel ledit substrat fourni (100) comporte une tranchée d'isolation (32) et dans lequel la deuxième grille factice (31) est formée sur ladite tranchée d'isolation.

10. Procédé de fabrication selon l'une quelconque des revendications précédentes, dans lequel ledit substrat (100) est de type Silicium sur isolant.

11. Procédé de fabrication selon l'une quelconque des revendications précédentes, comprenant la connexion lesdites première et deuxième électrodes (374, 375) de ladite cellule mémoire (3) à un circuit électronique configuré pour appliquer sélectivement une différence de potentiel entre les première et deuxième électrodes induisant un filament conducteur à travers ladite couche d'isolant de grille (107) déposée sur une paroi latérale de la deuxième gorge.

12. Procédé de fabrication selon l'une quelconque des revendications précédentes, comprenant :
- la formation de ladite couche d'encapsulation (106) ;
- préalablement à la formation de ladite couche d'encapsulation, un dépôt pleine plaque d'une couche isolante (104) recouvrant les première et deuxième grilles factices ;
- un masquage de ladite couche isolante (104) au niveau de la première grille factice (21) et le retrait de ladite couche isolante (104) au-dessus et de part et d'autre de la deuxième grille (31) factice ;
- la conservation d'une partie de ladite couche isolante (104) de part et d'autre de ladite électrode de grille (24) formée, de façon à former des espaceurs pour ladite électrode de grille (24).

13. Procédé de fabrication selon les revendications 5 et 12, dans lequel ledit masquage et ledit retrait sont réalisés préalablement à ladite formation de ladite couche d'encapsulation (106).

14. Procédé de fabrication selon les revendications 5 et 12, dans lequel ledit masquage et ledit retrait sont réalisés postérieurement à la formation desdites gorges additionnelles (28,29, 38).

15. Circuit intégré (1) incluant :
- un transistor à effet de champ (2) ;
- une cellule mémoire (3) de type OxRAM ;
- le transistor à effet de champ (2) et la cellule mémoire (3) sont inclus dans une couche d'avant métallisation et dans lequel une couche d'isolant de grille du transistor à effet de champ (2) et une couche d'isolant formant sélectivement un filament conducteur de la cellule mémoire (3) incluent un même matériau ; **caractérisé en ce que** :
- le transistor à effet de champ (2) comporte une électrode de grille, une électrode de source et une électrode de drain disposées au-dessus du substrat, les électrodes de source et de drain (274,275) dudit transistor étant disposées de part et d'autre de ladite électrode de grille ;
- la couche d'isolant de la cellule mémoire (3) s'étend sensiblement perpendiculairement au substrat, ladite cellule mémoire présentant des première et deuxième électrodes positionnées de part et d'autre de ladite couche d'isolant de grille.

## Patentansprüche

1. Verfahren zur Herstellung eines integrierten Schaltkreises (1), umfassend mindestens einen Feldeffekttransistor (2) und eine Speicherzelle (3) vom Typ OxRam, **dadurch gekennzeichnet, dass** es die folgenden Schritte umfasst:
- Bereitstellen eines Substrats (100), das eine Halbleiterschicht einschließt, wobei das Substrat mit einem ersten und einem zweiten Scheingate (21, 31) und einer Verkapselungsschicht (106) versehen ist, in der die Scheingates (21, 31) angeordnet sind, wobei mindestens das erste Scheingate auf der Halbleiterschicht des Substrats ausgebildet ist;
- Entfernern des ersten und des zweiten Scheingates, um eine erste und eine zweite Nut (23, 33) in die Verkapselungsschicht (106) einzuarbeiten;
- gleichzeitiges Anordnen einer Gate-Isolierschicht (107) mindestens im Boden der ersten Nut und an einer Seitenwand der zweiten Nut;
- Bilden einer Gate-Elektrode (24) des Transistors (2) in der ersten Nut über der Gate-Isolierschicht, Bilden einer Source- und einer Drain-Elektrode (274, 275) des Transistors beiderseits der Gate-Elektrode, Bilden der ersten und der zweiten Elektrode der Speicherzelle (374, 34) beiderseits der Gate-Isolierschicht, die an einer Seitenwand der zweiten Nut angeordnet ist.

2. Verfahren zur Herstellung eines integrierten Schaltkreises (1) nach Anspruch 1, umfassend die Bildung einer Isolierwand, die zwischen der ersten und der zweiten Elektrode (374, 34) der Speicherzelle (3) angeordnet ist, wobei diese Isolierwand die Gate-Isolierschicht (107), die an einer Seitenwand der zweiten Nut (33) angeordnet ist, einschließt und eine Dicke aufweist, die dimensioniert ist, um selektiv ein leitendes Filament beim Anlegen eines Potentialunterschieds zwischen der ersten und der zweiten Elektrode zu bilden.

3. Verfahren zur Herstellung eines integrierten Schaltkreises (1) nach Anspruch 2, umfassend ferner die Bildung einer zusätzlichen Isolierschicht (108) in der zweiten Nut (33) auf der Gate-Isolierschicht (107), wobei die zusätzliche Isolierschicht in die Isolierwand eingeschlossen ist, die zwischen der ersten und der zweiten Elektrode (374, 34) angeordnet ist.

4. Verfahren zur Herstellung eines integrierten Schaltkreises (1) nach einem der vorhergehenden Ansprüche, bei dem die aufgebrachte Gate-Isolierschicht (107) ein Material einschließt, das aus der Gruppe ausgewählt ist, umfassend HfO₂, HfSiON, HfAlO, TiOx, Al₂O₃ oder NiO.

5. Verfahren zur Herstellung eines integrierten Schaltkreises (1) nach einem der vorhergehenden Ansprüche, bei dem die Bildung der Source-Elektrode, der Drain-Elektrode und der ersten Elektrode der Speicherzelle die Bildung von zusätzlichen Nuten (28, 29, 38) in der Verkapselungsschicht (106) beiderseits der ersten Nut (23) und auf der Seite der zweiten Nut (33) einschließt.

6. Verfahren zur Herstellung eines integrierten Schaltkreises nach Anspruch 5, umfassend das Aufbringen einer Schutzschicht (26, 36) in der ersten und der zweiten Nut auf der Gate-Elektrode (24) bzw. der zweiten Elektrode (34) der Speicherzelle, wobei die Schutzschicht aus einem anderen Material als die Verkapselungsschicht gebildet ist, wobei die Bildung der zusätzlichen Nuten eine selbst-ausgerichtete Gravur der Verkapselungsschicht (106) beiderseits der Schutzschicht (26, 36) einschließt.

7. Verfahren zur Herstellung eines integrierten Schaltkreises nach Anspruch 5 oder 6, bei dem die Bildung der Source-Elektrode, der Drain-Elektrode und der ersten Elektrode der Speicherzelle einschließt:
- die Bildung einer Titanschicht (110) an den Wänden der zusätzlichen Nuten;
- die Bildung einer Titannitridschicht (111) auf der Titanschicht;
- das Aufbringen einer metallischen Schicht auf der Titanschicht.

8. Herstellungsverfahren nach einem der vorhergehenden Ansprüche, bei dem die erste für die Speicherzelle (3) gebildete Elektrode auch eine der Source- oder der Drain-Elektrode, die für den Transistor (2) gebildet werden, bildet.

9. Herstellungsverfahren nach einem der vorhergehenden Ansprüche, bei dem das bereitgestellte Substrat (100) einen Isolierabschnitt (32) umfasst, und bei dem das zweite Scheingate (31) auf dem Isolierabschnitt gebildet ist.

10. Herstellungsverfahren nach einem der vorhergehenden Ansprüche, bei dem das Substrat (100) vom Typ Silizium auf Isolator ist.

11. Herstellungsverfahren nach einem der vorhergehenden Ansprüche, umfassend den Anschluss der ersten und der zweiten Elektrode (374, 375) der Speicherzelle (3) an eine elektronische Schaltung, die dazu vorgesehen ist, selektiv einen Potentialunterschied zwischen der ersten und der zweiten Elektrode anzulegen, der ein leitendes Filament über die Gate-Isolierschicht (107), die an einer Seitenwand der zweiten Nut angeordnet ist, induziert.

12. Herstellungsverfahren nach einem der vorhergehenden Ansprüche, umfassend:
- die Bildung der Verkapselungsschicht (106);
- vor der Bildung der Verkapselungsschicht ein Aufbringen in voller Platte einer Isolierschicht (104), die das erste und das zweite Scheingate bedeckt;
- ein Verdecken der Isolierschicht (104) im Bereich des ersten Scheingates (21) und das Entfernen der Isolierschicht (104) über und beiderseits des zweiten Scheingates (31);
- die Bewahrung eines Teils der Isolierschicht (104) beiderseits der gebildeten Gate-Elektrode (24), um Abstandshalter für die Gate-Elektrode (24) zu bilden.

13. Herstellungsverfahren nach den Ansprüchen 5 und 12, bei dem das Verdecken und Entfernen vor der Bildung der Verkapselungsschicht (106) erfolgt.

14. Herstellungsverfahren nach den Ansprüchen 5 und 12, bei dem das Verdecken und Entfernen nach der Bildung der zusätzlichen Nuten (28, 29, 38) erfolgt.

15. Integrierter Schaltkreis (1), umfassend:
- einen Feldeffekttransistor (2);
- eine Speicherzelle (3) vom Typ OxRAM;
- wobei der Feldeffekttransistor (2) und die Speicherzelle (3) in eine Vormetallisierungsschicht eingeschlossen sind, und wobei eine Gate-Isolierschicht des Feldeffekttransistors (2) und eine Isolierschicht, die selektiv ein leitendes Filament der Speicherzelle (3) bilden, ein selbes Material einschließen;
**dadurch gekennzeichnet, dass**:
- der Feldeffekttransistor (2) eine Gate-Elektrode, eine Source-Elektrode und eine Drain-Elektrode umfasst, die über dem Substrat angeordnet sind, wobei die Source- und die Drain-Elektrode (274, 275) des Transistors beiderseits der Gate-Elektrode angeordnet sind;
- sich die Isolierschicht der Speicherzelle (3) im Wesentlichen senkrecht zum Substrat erstreckt, wobei die Speicherzelle eine erste und eine zweite Elektrode aufweist, die beiderseits der Gate-Isolierschicht positioniert sind.

## Claims

1. Process for fabricating an integrated circuit (1) including at least one field-effect transistor (2) and a memory cell (3) of OxRam type, **characterized in that** it comprises the steps of:
- providing a substrate (100) that includes a semiconductor layer, the substrate being equipped with first and second dummy gates (21, 31) and with an encapsulation layer (106) in which said dummy gates (21, 31) are positioned, at least the first dummy gate being formed on the semiconductor layer of the substrate;
- removing the first and second dummy gates in order to make first and second grooves (23, 33) in said encapsulation layer (106);
- simultaneously depositing a gate insulating layer (107) at least in the bottom of the first groove and on a side wall of the second groove;
- forming a gate electrode (24) of said transistor (2) in the first groove on top of said gate insulating layer, forming source and drain electrodes (274, 275) of said transistor on either side of said gate electrode, forming first and second electrodes of said memory cell (374, 34) on either side of said gate insulating layer deposited on a side wall of the second groove.

2. Process for fabricating an integrated circuit (1) according to Claim 1, comprising the formation of an insulating wall positioned between said first and second electrodes (374, 34) of the memory cell (3), this insulating wall including said gate insulating layer (107) deposited on a side wall of the second groove (33), and having a thickness sized in order to selectively form a conductive filament during the application of a potential difference between the first and second electrodes.

3. Process for fabricating an integrated circuit (1) according to Claim 2, also comprising the formation of an additional insulating layer (108) in said second groove (33) on said gate insulating layer (107), said additional insulating layer being included in said insulating wall positioned between said first and second electrodes (374, 34).

4. Process for fabricating an integrated circuit (1) according to any one of the preceding claims, in which said deposited gate insulating layer (107) includes a material selected from the group comprising HfO₂, HfSiON, HfAlO, TiOx, Al₂O₃ or NiO.

5. Process for fabricating an integrated circuit (1) according to any one of the preceding claims, in which the formation of the source and drain electrodes and said first electrode of the memory cell includes the formation of additional grooves (28, 29, 38) in the encapsulation layer (106), on either side of the first groove (23) and to the side of the second groove (33).

6. Process for fabricating an integrated circuit according to Claim 5, comprising the deposition of a protective layer (26, 36) in the first and second grooves respectively on said gate electrode (24) and said second electrode (34) of the memory cell, said protective layer being formed from a material different from the encapsulation layer, the formation of said additional grooves including a self-aligned etching of the encapsulation layer (106) on either side of the protective layer (26, 36).

7. Process for fabricating an integrated circuit according to Claim 5 or 6, in which the formation of the source and drain electrodes and said first electrode of the memory cell includes:
- the formation of a titanium layer (110) on the walls of said additional grooves;
- the formation of a titanium nitride layer (111) on the titanium layer;
- the deposition of a metal layer on said titanium layer.

8. Fabrication process according to any one of the preceding claims, in which said first electrode formed for said memory cell (3) also forms one of said source or drain electrodes formed for said transistor (2).

9. Fabrication process according to any one of the preceding claims, in which said substrate provided (100) comprises an isolation trench (32) and in which the second dummy gate (31) is formed on said isolation trench.

10. Fabrication process according to any one of the preceding claims, in which said substrate (100) is of silicon-on-insulator type.

11. Fabrication process according to any one of the preceding claims, comprising the connection of said first and second electrodes (374, 375) of said memory cell (3) to an electronic circuit configured in order to selectively apply a potential difference between the first and second electrodes inducing a conductive filament across said gate insulating layer (107) deposited on a side wall of the second groove.

12. Fabrication process according to any one of the preceding claims, comprising:
- the formation of said encapsulation layer (106);
- prior to the formation of said encapsulation layer, a blanket deposition of an insulating layer (104) covering the first and second dummy gates;
- a masking of said insulating layer (104) at the first dummy gate (21) and the removal of said insulating layer (104) on top of and either side of the second dummy gate (31);
- the preservation of a portion of said insulating layer (104) on either side of said gate electrode (24) formed, so as to form spacers for said gate electrode (24).

13. Fabrication process according to Claims 5 and 12, in which said masking and said removal are carried out prior to said formation of said encapsulation layer (106).

14. Fabrication process according to Claims 5 and 12, in which said masking and said removal are carried out subsequent to the formation of said additional grooves (28, 29, 38).

15. Integrated circuit (1) including:
- a field-effect transistor (2);
- a memory cell (3) of OxRam type;
- the field-effect transistor (2) and the memory cell (3) are included in a pre-metallization layer and in which a gate insulating layer of the field-effect transistor (2) and an insulating layer selectively forming a conductive filament of the memory cell (3) include a same material;
**characterized in that**:
- the field-effect transistor (2) comprises a gate electrode, a source electrode and a drain electrode positioned on top of the substrate, the source and drain electrodes (274, 275) of said transistor being positioned on either side of said gate electrode;
- the insulating layer of the memory cell (3) extends substantially perpendicular to the substrate, said memory cell having first and second electrodes positioned on either side of said gate insulating layer.
